# EUROPÄISCHE PATENTSCHRIFT

(11) **EP 3 262 453 B1**
(45) Veröffentlichungstag und Bekanntmachung des Hinweises auf die Patenterteilung: **30.11.2022**
(21) Anmeldenummer: 16709303.8
(22) Anmeldetag: 24.02.2016
(51) Int. Cl.: G02B 21/00, G01J 1/44, H01L 31/107, G01J 1/42, G01J 3/02, G01J 3/28

(54) **VERFAHREN ZUR VERBESSERUNG DES DYNAMIKBEREICHS EINER VORRICHTUNG ZUM DETEKTIEREN VON LICHT**
METHOD FOR IMPROVING THE DYNAMIC RANGE OF A DEVICE FOR DETECTING LIGHT
PROCÉDÉ PERMETTANT D'AMÉLIORER LA PLAGE DYNAMIQUE D'UN DISPOSITIF DE PHOTODÉTECTION

(30) Priorität: 24.02.2015 LU 92665
(43) Veröffentlichungstag der Anmeldung: 03.01.2018
(73) Patentinhaber: Leica Microsystems CMS GmbH, 35578 Wetzlar (DE)
(72) Erfinder: DYBA, Marcus, 69121 Heidelberg (DE)
(74) Vertreter: Bradl, Joachim
(86) Internationale Anmeldenummer: PCT/EP2016/053832
(87) Internationale Veröffentlichungsnummer: WO 2016/135178

(56) Entgegenhaltungen:
- EP-A1- 1 928 167
- EP-A1- 2 546 621
- WO-A1-2013/093035
- WO-A1-2014/066813
- US-A1- 2011 095 192

## Beschreibung

Die Erfindung betrifft ein Verfahren zur Verbesserung des Dynamikbereichs einer Vorrichtung zum Detektieren von Licht. Des Weiteren betrifft die Erfindung eine entsprechende Vorrichtung. Ferner betrifft die Erfindung ein Mikroskop mit einer entsprechenden Vorrichtung.

Licht im Sinne der Erfindung stellt jegliche elektromagnetische Strahlung dar, die durch Silizium-Photomultiplier (SiPM) bzw. Single-Photon-Avalanche-Dioden (SPAD) detektiert werden kann, insbesondere sichtbares Licht, Infrarotlicht, UV-Licht, Röntgenstrahlung und Gammastrahlung. So ist der Begriff der Lichtintensität im Rahmen dieser Anmeldung folglich ein Synonym zum Begriff der Strahlungsintensität. Beispielhaft, nicht etwa einschränkend, lässt sich die Erfindung in einem Laser-Raster-Mikroskop verwenden.

Vorrichtungen und Verfahren zum Detektieren von Licht sind seit vielen Jahren aus der Praxis bekannt und werden beispielsweise in Laser-Raster-Mikroskopen eingesetzt. Dabei sind entsprechende Vorrichtungen, die das Detektionssignal der zu mikroskopierenden Probe erfassen, von zentraler Bedeutung für die Bildqualität. Dies gilt vor allem für vergleichsweise schwache Detektionssignale, wie sie in der (konfokalen) Fluoreszenz-Mikroskopie, der SHG-Mikroskopie oder der Raman-Mikroskopie typisch sind.

Für Lichtdetektoren sind zwei Kenngrößen von besonderer Bedeutung, das Detektorrauschen und die Quantenausbeute, d.h. die Detektionseffizienz. Die Quantenausbeute beschreibt dabei den Anteil des auf den Detektor treffenden Lichts, der tatsächlich ein verwertbares elektrisches Signal erzeugt. Das Rauschen beschreibt das elektronische Grundsignal, das dem eigentlichen Detektionssignal störend überlagert ist. Das Verhältnis dieser beiden Größen, das sogenannte Signal-Rausch-Verhältnis (SRN, "Signal to Noise Ratio") ist eine der zentralen Kenngrößen eines Lichtdetektors.

In der Praxis sind seit vielen Jahren Fotomultiplier (PMT) die dominierenden Lichtdetektoren in der Laser-Raster-Mikroskopie. Im Vergleich zu Halbleiter-basierten Detektoren - z.B. Fotodioden - haben PMT eine geringere Quantenausbeute. Sie bieten aufgrund ihres geringen Rauschens jedoch ein sehr gutes SNR. Des Weiteren sind in den letzten Jahren verbesserte Varianten mit einer GaAsP-Schicht (Galliumarsenidphosphid) als lichtempfindliches Medium verfügbar.

Ferner ist seit einigen Jahren bekannt, alternativ Halbleiter-Detektoren in der Fluoreszenz-Mikroskopie einzusetzen. Dabei spielen vor allem Einzelphoton-Lawinendioden, sog. "Single-Photon-Avalanche-Dioden" (SPAD) eine große Rolle. Die SPADs arbeiten im Geigermodus.

Dabei wird eine Sperrspannung an die SPADs angelegt, die knapp oberhalb der Durchbruchspannung liegt. Die Durchbruchspannung beträgt dabei einige hundert Volt.

In diesem Modus erzeugt ein absorbiertes Photon ein Elektron-Loch-Paar im Halbleiter, das durch das starke elektrische Feld beschleunigt wird und weitere Stoß-Ionisationen durchführt. Dieser Prozess setzt sich lawinenartig fort und löst eine messbare Ladungslawine aus, die um einen Faktor von einigen Millionen verstärkt ist. Somit können einzelne absorbierte Photonen gemessen werden, wodurch diese Detektoren für die Messung extrem geringer Lichtmengen eingesetzt werden können, wie sie beispielsweise in der Fluoreszenz-Mikroskopie üblich sind.

Ein einzelnes Photon führt dabei zu einer elektrischen Entladung, die in Form eines kurzen Spannungspulses gemessen wird. Es gibt dabei grundsätzlich zwei Mess-Modi. Im digitalen Messmodus werden die Spannungspulse gezählt, wobei die steigende Spannungsflanke als auslösendes Zählsignal dient. Alternativ kann die Ladung im sog. analogen Messmodus über einen Messwiderstand integriert und die gesammelte Ladungsmenge aller Pulse als Messsignal genutzt werden. Typischerweise wird die integrierte Ladungsmenge aller Pulse eines festgelegten Zeitintervalls (Pixel-Belichtungszeit) dann durch einen Analog-DigitalWandler digitalisiert zur weiteren digitalen Verarbeitung.

Unabhängig von dem gewählten Messmodus ist bei den SPADs problematisch, dass eine Sättigung des Signals auftritt. Im Konkreten steigt dabei das Messsignal bei einer zunehmenden Lichtmenge, die auf den Detektor tritt, nicht mehr im gleichen Maße an. Der gewünschte lineare Zusammenhang zwischen Ein- und Ausgangssignal ist somit nicht mehr gegeben. Die Sättigung tritt auf, da während einer Lawinenentladung der SPADs ein weiteres absorbiertes Photon keine gleichzeitige, zweite Lawine auslösen kann. Somit besteht nach einer Pulsauslösung eine Totzeit der SPADs, in der eine Detektion nicht erfolgen kann. Diese Totzeit entspricht der Zeit, die benötigt wird, um die während der Lawinenentladung verarmten Ladungsträger im Halbleiter wieder aufzuladen. Große Lichtmengen, bei denen mehrere Photonen innerhalb der Totzeit eintreffen, können daher nicht mehr vollständig erfasst werden und der Detektor zeigt eine nicht-lineare Sättigungskennkurve.

Da der daraus resultierende geringe Dynamikbereich der Detektoren mit einer maximalen Zählrate von einigen 10⁶ bis 10⁷ Photonen pro Sekunde ein Problem dieser hochempfindlichen Detektoren darstellt, wurden in den letzten Jahren sog. SPAD-Arrays entwickelt. Diese sind bspw. von dem Hersteller Hamamatsu Photonics K.K. unter dem Namen MPPC-Detektor (Multi-Pixel Photon Counting Detector) verfügbar. In der Literatur werden diese Detektoren u.a. auch als Silicium-Photomultiplier (SiPM) bezeichnet. Die Funktion entsprechender Detektoren ist beispielsweise unter https://www.hamamatsu.com/resources/pdf/ssd/mppc_techinfo_e.pdf beschrieben.

Das Grundprinzip eines SPAD-Arrays besteht darin, dass mehrere einzelne SPADs zu einem Feld parallel zusammengeschaltet sind. Trifft ein Photon auf eine einzelne SPAD, so ist diese aufgrund ihrer Totzeit für eine Zeit von typischerweise einigen Nanosekunden nicht mehr empfindlich. Andere SPADs, auf die ein weiteres Photon innerhalb dieser Zeit oder auch gleichzeitig auftrifft, können dieses jedoch erfassen und einen messbaren Ladungsimpuls erzeugen. Folglich kann am Detektorausgang eine Pulsfolge mit höherer Zählrate entstehen als bei einem einzelnen SPAD.

Somit ist aus dem Stand der Technik bekannt, das gesamte Detektionslicht auf mehrere, parallel geschaltete SPADs zu verteilen. Dies hat den Vorteil, dass einzelne SPADs nur mit einem Bruchteil des Detektionslichts beaufschlagt werden und die Sättigung dieser SPADs somit später eintritt. Des Weiteren stehen während der Totzeit einer individuellen SPAD weitere empfangsbereite SPADs zur Verfügung. Der Dynamikbereich dieser Detektoren ist daher wesentlich erhöht, abhängig von der Anzahl der parallel geschalteten SPADs. Kommerziell erhältliche SPAD-Arrays weisen beispielsweise 20x20 oder mehr SPADs auf.

Jedoch ist auch bei den bekannten SPAD-Arrays problematisch, dass diese ein Sättigungsverhalten aufweisen. Sättigung kann eintreten, wenn zu viele Photonen innerhalb der Totzeit auf dieselbe SPAD treffen. In diesem Fall ist die Sättigung analog zur Sättigung einer einzelnen SPAD. Ferner kann im digitalen Detektionsmodus auch eine Sättigung auftreten, wenn die - steigenden - Auslöseflanken eines Pulses während eines vorigen Pulses nicht zum erneuten Auslösen des digitalen Zählers führen, da ihr Spannungsniveau über der Spannungsschwelle zur Zählerauslösung liegt - sog. Trigger-Level - und daher von der Zähleinheit nicht als Pulsflanke erfasst wird.

Beide genannten Effekte führen zu einer Sättigung auch von SPAD-Arrays. Aus der Praxis ist bekannt, dass beispielsweise ab ca. 10⁸ auftreffenden Photonen pro Sekunde das Ausgangssignal - die Anzahl der elektrischen Entladungen - einen nahezu konstanten Wert annimmt, so dass eine Messung der Lichtmenge nicht mehr präzise möglich ist. Sofern die Kennkurve - spezifisch für ein gegebenes Detektordesign - bekannt ist, kann sie durch rechnerische Korrektur linearisiert werden. Im Bereich fast vollständiger Sättigung - beispielsweise etwas oberhalb von 10¹¹ Photonen pro Sekunde - ist eine rechnerische Korrektur jedoch nicht mehr präzise genug möglich. Da eine Kennkurve im analogen Messmodus einen nahezu identischen Verlauf wie im digitalen Messmodus aufzeigt, wird im Folgenden nicht mehr zwischen den verschiedenen Sättigungsursachen unterschieden.

Das parallele Zusammenschalten vieler SPADs zu einem SPAD-Array stellt daher zwar eine Verbesserung der Sättigungsproblematik dar, diese ist jedoch nach wie vor vorhanden.

Somit liegt der Dynamikbereich bekannter SPAD-Arrays immer noch weiter unter dem Dynamikbereich von Fotomultipliern, die daher nach wie vor zur Detektion geringer Lichtmengen eingesetzt werden, obwohl ihre Detektionseffizienz schlechter ist als die von SPAD-Detektoren.

Ein Verfahren zur Verbesserung der Auflösung bei gleichzeitig großem Dynamikbereich ist aus der WO 2013/093035 A1 bekannt. Dabei werden unterschiedliche Sensoren mit verschiedenen Intensitäten von Beleuchtungslicht beaufschlagt, was entweder durch Dämpfungsmittel oder unterschiedliche Platzierungen der einzelnen Sensoren im beleuchteten Bereich erreicht wird. Die Sensoren werden dabei hinsichtlich ihrer Vorspannung derart eingestellt, dass sie in unterschiedlichen Intensitätsbereichen des einfallenden Lichts im linearen Bereich arbeiten. Die von den Sensoren gelieferten Signal werden dann von einem Algorithmus gewichtet und kombiniert, um ein Gesamtsignal zu erhalten.

Der vorliegenden Erfindung liegt daher die Aufgabe zugrunde, ein Verfahren und eine Vorrichtung zum Detektieren von Licht anzugeben, wonach bei hoher Empfindlichkeit, optimiertem Signal-zu-Rauschen-Verhältnis und geringen Herstellungskosten eine Vergrößerung des effektiven Dynamikbereichs und der Detektionseffizienz sowie eine Linearisierung der Kennkurve realisierbar ist. Dabei soll das Verfahren die grundlegenden Eigenschaften der Vorrichtung nicht ändern. Ein entsprechend ausgestattetes Mikroskop soll angegeben werden.

Voranstehende Aufgabe ist in Bezug auf das erfindungsgemäße Verfahren durch die Merkmale des Anspruchs 1 gelöst. In Bezug auf die erfindungsgemäße Vorrichtung ist die Aufgabe durch die Merkmale des nebengeordneten Anspruchs 6 gelöst.

Erfindungsgemäß umfasst das Verfahren die Verwendung einer Vorrichtung zum Detektieren von Licht mit mindestens zwei Detektionsbereichen, wobei die Detektionsbereiche jeweils aus einer Anordnung (Array) aus mehreren Single-Photon-Avalanche-Dioden (SPAD) gebildet werden und wobei die Detektionsbereiche jeweils zumindest einen Signal-Ausgang aufweisen. Dabei wird für jeden der Detektionsbereiche eine Kennkurve ermittelt und werden die Kennkurven zum Erhalt einer Korrekturkurve und/oder eines Korrekturfaktors miteinander kombiniert und/oder verrechnet.

Erfindungsgemäß ist dabei erkannt worden, dass sich die eigentlich nachteilhafte inhomogene Ausleuchtung des Arrays aus SPADs vorteilhaft nutzen lässt, um die Vorrichtung zum Detektieren von Licht über einen weit größeren Dynamikbereich - dem Bereich einfallender Gesamt-Lichtmenge - mit einer linearen Kennkurve zu betreiben, bzw. zu korrigieren, als dies normalerweise bei homogener Ausleuchtung der Fall wäre.

Die nach dem Stand der Technik bekannten SPAD-Arrays werden in der (konfokalen) Laser-Raster-Mikroskopie so eingesetzt, dass das Detektionslicht hinter der konfokalen Lochblende mit klassischen Optikelementen auf die Detektorfläche fokussiert wird. Das hinter der Lochblende divergent austretende Licht wird mittels Linsen auf den Detektor abgebildet, so dass eine gaußartige Lichtverteilung (genauer eine Airy-Verteilung) auf der Detektoroberfläche entsteht. Dabei ist wesentlich, dass nahezu das gesamte Licht auf die Detektionsfläche und nur vernachlässigbar wenig Licht neben die Detektionsfläche trifft. Dies ist erforderlich, um eine hohe Detektionseffizienz zu erzielen. Bei gaußartiger Verteilung des Detektionslichts trifft als Konsequenz eine deutlich geringere Lichtintensität auf die außen liegenden SPADs im Vergleich zu den im zentralen Bereich der Detektionsfläche liegenden SPADs. Beispielsweise werden die äußeren SPADs mit weniger als 10% der Zentralintensität (der Lichtintensität im geometrischen Mittelpunkt des SPAD-Arrays) beleuchtet. Die nächsten, weiter innen liegenden SPADs werden beispielsweise nur mit etwa 31% der Zentralintensität beleuchtet. In erfindungsgemäßer Weise ist dabei erkannt worden, dass die inneren SPADs deutlich früher einen Sättigungseffekt als die außenliegende SPADs zeigen. Somit zeigt der entsprechend beleuchtete Detektor schon bei geringen Gesamtlichtmengen eine nicht-lineare Kennkurve.

Für die Bildgebung ist jedoch eine lineare Kennkurve von großer Bedeutung für eine quantitativ korrekte Bildaufnahme der zu mikroskopierenden Probe. Ein einfacher und bekannter Ansatz ist, die bekannte nicht-lineare Kennkurve durch einen Korrekturfaktor zu linearisieren. Dies ist im Übergangsbereich nach Einsetzen der Sättigung auch gut möglich. Sobald die Kennkurve jedoch zu stark abgeflacht ist, also nicht mehr sensibel auf steigende Lichtmengen reagiert, trifft diese simple Korrektur schnell an ihre Grenzen.

In weiter erfindungsgemäßer Weise ist nunmehr erkannt worden, dass eine Linearkorrektur in verblüffend einfacher Weise durchgeführt werden kann, indem die Kennkurven der Detektionsbereiche zur Ermittlung einer Korrekturkurve und/oder eines Korrekturfaktors miteinander kombiniert und/oder verrechnet werden. Dabei wird der Detektionsbereich, der mit einem geringeren Lichtanteil beaufschlagt wird, im Sinne eines "Linearitäts-Sensors" genutzt, da dessen Kennkurve noch ein lineares bzw. weniger gesättigtes Ausgangsignal aufweist, wenn der mit einer höheren Lichtintensität beaufschlagte Detektionsbereich bereits in Sättigung gegangen ist.

In vorteilhafter Weise kann dabei eine aus den Ausgangssignalen der Signal-Ausgänge gebildete Gesamtkennkurve anhand der Korrekturkurve und/oder des Korrekturfaktors korrigiert, insbesondere linearisiert, werden. Dadurch ist mit geringem Aufwand und unter Beibehaltung der grundlegenden Eigenschaften der Vorrichtung zum Detektieren von Licht der Dynamikbereich um mindestens eine Größenordnung verbessert.

Dabei werden die Korrekturkurve und/oder der Korrekturfaktor durch Division der Kennkurven der einzelnen Detektionsbereiche ermittelt. Somit wird der lineare Verlauf der mit einer geringeren Lichtintensität beaufschlagten Detektionsbereiche in verblüffend einfacher Weise zur Verbesserung des Dynamikbereichs verwendet.

Des Weiteren ist denkbar, dass die Korrektur der Ausgangssignale nach der eigentlichen Detektion des Lichts durch digitale Signalverarbeitung, beispielsweise durch einen digitalen Signalprozessor (DSP) oder ein Field Programmable Gate Array (FPGA) oder einen Rechner, erfolgt.

In vorteilhafter Weise werden die Kennkurven der Detektionsbereiche durch eine Kalibriermessung einmal bestimmt. Insbesondere bei einer Anwendung des erfindungsgemäßen Verfahrens in einem Mikroskop ist bei einem gegebenen Design der Vorrichtung zur Detektion von Licht und der Optik des Mikroskops die Kennkurve festgelegt. Daher muss die Kalibriermessung für ein gegebenes Gerätedesign lediglich einmal durchgeführt werden.

Um den Dynamikbereich in besonders hohem Maße zu verbessern, können die Detektionsbereiche mit unterschiedlichen Intensitäten und/oder unterschiedlichen spektralen Bereichen des zu detektierenden Lichts beaufschlagt werden. In idealer Weise sollte dabei der mit einer geringeren Intensität beaufschlagte Detektionsbereich bereits ein ausreichend gutes SNR liefern, sobald der mit hoher Intensität beaufschlagte Detektionsbereich in den problematischen Sättigungsbereich kommt.

Zur weiteren Flexibilisierung ist es vorteilhaft, wenn die Korrektur der Ausgangssignale im Bedarfsfall zugeschaltet wird.

Die erfindungsgemäße Vorrichtung löst die eingangs genannte Aufgabe durch die Merkmale des nebengeordneten Anspruchs 8. Danach weist die Vorrichtung zum Detektieren von Licht mindestens zwei Detektionsbereiche auf, wobei die Detektionsbereiche jeweils aus einer Anordnung (Array) aus mehreren Single-Photon-Avalanche-Dioden (SPAD) gebildet sind und wobei die Detektionsbereiche jeweils zumindest einen Signal-Ausgang aufweisen.

Hier gelten die gleichen Ausführungen wie zum erfindungsgemäßen Verfahren, wobei wesentlich ist, dass mindestens zwei separat auszulesende Detektionsbereiche vorgesehen sind, so dass ein mit geringerer Lichtintensität beaufschlagter Detektionsbereich als "Linearitäts-Sensor" nutzbar ist.

Insbesondere bei einer gaußartigen Lichtverteilung ist es besonders vorteilhaft, wenn ein erster, innerer Detektionsbereich und ein zweiter, äußerer Detektionsbereich angeordnet sind, wobei der zweite Detektionsbereich den ersten Detektionsbereich umschließt. Der innere Detektionsbereich wird damit mit einer höheren Lichtintensität beaufschlagt, so dass der äußere, zweite Detektionsbereich als "Linearitäts-Sensor" dient.

Ferner können mindestens zwei Detektionsbereiche jeweils als Teil-Array eines Silicium-Photomultipliers (SiPM) ausgebildet sein. Somit wird lediglich ein SiPM benötigt, der die mindestens zwei Detektionsbereiche realisiert.

Des Weiteren ist vorstellbar, dass die mindestens zwei Detektionsbereiche als Array jeweils eines SiPM ausgebildet sind. Somit können gängige SiPM zur Realisierung der Detektionsbereiche verwendet werden, so dass die Vorrichtung besonders günstig in der Herstellung ist. Dabei ist von besonderem Vorteil, wenn ein Strahlteiler angeordnet ist, so dass das zu detektierende Licht auf die mindestens zwei SiPM aufteilbar ist.

Des Weiteren ist denkbar, dass ein dispersives Element, insbesondere ein Prisma oder ein Gitter, derart angeordnet ist, dass die Detektionsbereiche mit unterschiedlichen Spektralanteilen des zu detektierenden Lichts beaufschlagbar sind. Dabei kann jeder Spektralbereich beispielsweise getrennt linearisierbar sein, so dass bessere Rückschlüsse auf die spektrale Verteilung in einer mikroskopischen Probe ermöglicht sind, beispielsweise bei Farbstoffgemischen.

In vorteilhafter Weise können die Detektionsbereiche symmetrisch oder asymmetrisch zueinander angeordnet sein, so dass eine möglichst flexible Anpassung an die weiteren Komponenten erfolgen kann. Dabei ist auch denkbar, dass die Detektionsbereiche eine runde oder nahezu runde Detektionsfläche bilden.

In bevorzugter Weise kann ein Verarbeitungsmodul zur digitalen Signalverarbeitung von Ausgangssignalen der Signal-Ausgänge angeordnet sein. Das Verarbeitungsmodul kann als digitaler Signalprozessor (DSP) oder als Field Programmable Gate Array (FPGA) ausgebildet sein.

Um eine weitere Flexibilisierung der Vorrichtung zu realisieren, können die Ausgangssignale der Signal-Ausgänge der Detektionsbereiche, zu einem einzigen Gesamtsignal zusammenschaltbar bzw. zusammenfügbar sein, beispielsweise elektronisch oder in einem nachgelagerten Rechner.

Eine Anwendung der erfindungsgemäßen Vorrichtung in einem Mikroskop, insbesondere einem Rastermikroskop, vorzugsweise einem Laser-Raster-Mikroskop, ist von besonderem Vorteil. Dabei kann es sich um ein Mikroskop zur Fluoreszenz-Mikroskopie und/oder zur Raman-Mikroskopie handeln. Alternativ oder zusätzlich ist denkbar, dass es sich um ein Mikroskop zur Second-Harmonic-Generation (SHG)-Mikroskopie handelt.

Es gibt nun verschiedene Möglichkeiten, die Lehre der vorliegenden Erfindung in vorteilhafter Weise auszugestalten und weiterzubilden. Dazu ist einerseits auf die den Ansprüchen 1 und 8 nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert.

In der Zeichnung zeigen
- Fig. 1: das von einer SPAD gemessene Spannungssignal in Abhängigkeit von der Zeit,
- Fig. 2: in einer schematischen Ansicht den grundsätzlichen Aufbau eines aus mehreren SPADs gebildeten Arrays,
- Fig. 3: eine Kennkurve eines aus dem Stand der Technik bekannten Arrays, betrieben im digitalen Messmodus,
- Fig. 4: in schematischer Ansicht das auf ein in einem Laser-Raster-Mikroskop angeordnetes Array auftreffende Licht,
- Fig. 5: in schematischer Ansicht ein Array eines ersten Ausführungsbeispiels einer erfindungsgemäßen Vorrichtung,
- Fig. 6: in einer schematischen Ansicht die von der erfindungsgemäßen Vorrichtung nach Fig. 5 erzeugten Pulsfolgen,
- Fig. 7: die Kennkurven der erfindungsgemäßen Vorrichtung gemäß Fig. 5,
- Fig. 8: ein Beispiel einer durch ein erfindungsgemäßes Verfahren erzeugten Korrekturkurve für eine erfindungsgemäße Vorrichtung nach Fig. 5 und
- Fig. 9: die mit dem erfindungsgemäßen Verfahren linearisierte Kennkurve aus Fig. 7.

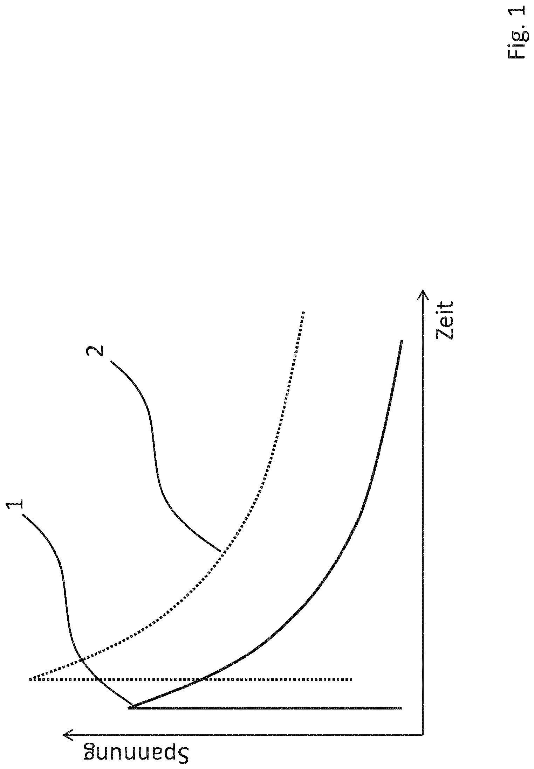

Fig. 1 zeigt das von einer SPAD gemessene Spannungssignal in Abhängigkeit von der Zeit. Anhand von Fig. 1 ist die Sättigung des Messsignals einer aus dem Stand der Technik bekannten SPAD erkennbar. Ein einzelnes Photon führt zu einer elektrischen Entladung, die in Form eines kurzen Spannungspulses 1 gemessen wird. Während einer Lawinenentladung der SPAD kann ein weiteres absorbiertes Photon keine gleichzeitige, zweite Lawine auslösen, wie dies durch den punktiert dargestellten Spannungspuls 2 angedeutet ist. Somit existiert nach einer Pulsauslösung eine Totzeit, in der die SPAD kein weiteres Licht detektieren kann.

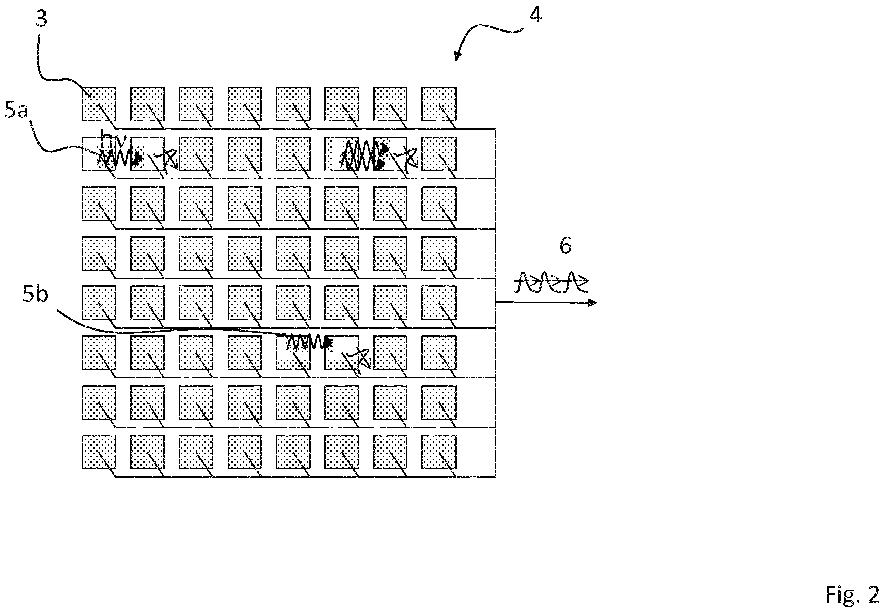

Fig. 2 zeigt in einer schematischen Ansicht den grundsätzlichen Aufbau eines bekannten aus mehreren SPADs 3 gebildeten Arrays 4. Zur besseren Darstellung ist in Fig. 2 und den folgenden Figuren lediglich ein SPAD 3 mit einem Bezugszeichen versehen. Dabei sind mehrere einzelne SPADs 3 zu einem Array 4 parallel zusammengeschaltet. Trifft ein Photon 5a auf eine einzelne SPAD 3, so ist diese aufgrund ihrer Totzeit für einige Nanosekunden nicht mehr empfindlich. Andere SPADs 3, auf die ein weiteres Photon 5b innerhalb dieser Zeit oder auch gleichzeitig auftrifft, können das Photon 5b jedoch erfassen und einen messbaren Ladungsimpuls erzeugen. Es kann so eine Pulsfolge 6 am Detektorausgang entstehen, die eine höhere Zählrate als bei einer einzelnen SPAD 3 aufweist.

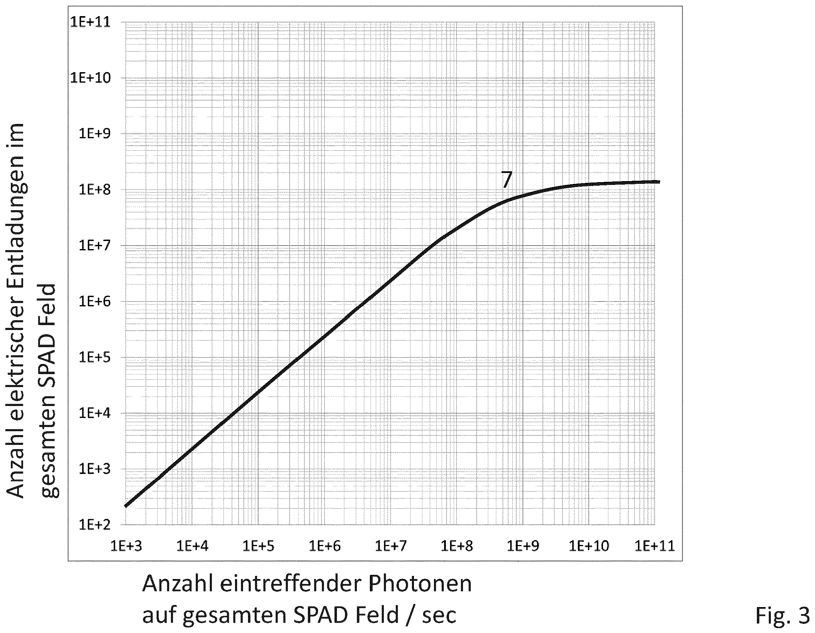

Fig. 3 zeigt eine Kennkurve 7 eines aus dem Stand der Technik bekannten Arrays 4, betrieben im digitalen Messmodus. Dabei ist im Konkreten die Anzahl der elektrischen Entladungen im gesamten SPAD-Feld (Array) gegen die Anzahl der eintreffenden Photonen auf das gesamte SPAD-Feld pro Sekunde in einer doppelt logarithmischen Skala aufgetragen. Ab ca. 10⁸ auftreffenden Photonen pro Sekunde wird die Kurve nicht-linear aufgrund des Sättigungsverhaltens. Oberhalb von etwa 10¹¹ Photonen pro Sekunde wird das Ausgangssignal (Anzahl der elektrischen Entladungen) sogar nahezu konstant, so dass eine Messung der Lichtmenge nicht mehr präzise möglich ist. Sofern die Kennkurve 7, die für ein gegebenes Detektordesign spezifisch ist, bekannt ist, kann sie durch rechnerische Korrektur linearisiert werden. Im Bereich fast vollständiger Sättigung, d.h. etwa oberhalb 10¹¹ Photonen pro Sekunde ist dies jedoch nicht mehr präzise genug möglich. Während Fig. 3 eine Kennkurve 7 für den digitalen Messmodus zeigt, gilt gleiches auch für den analogen Messmodus.

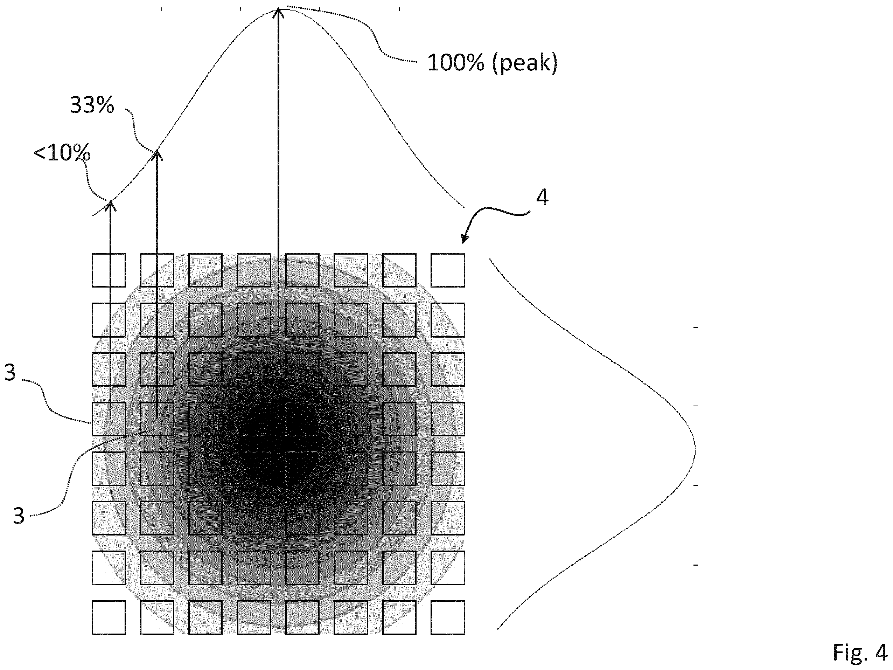

Fig. 4 zeigt in schematischer Ansicht das auf einen in einem (konfokalen) Laser-Raster-Mikroskop angeordneten, bekannten Array 4 auftreffende Licht. Dabei ist deutlich erkennbar, dass beispielsweise die im Randbereich angeordneten SPADs 3 des Arrays 4 mit weniger als 10% der Zentralintensität beleuchtet werden. Die nächste, weiter innen liegende SPAD 3 wird ebenfalls nur mit etwa 33% der Zentralintensität beleuchtet. Daher werden die inneren SPADs 3 deutlich früher einen Sättigungseffekt nach Art der in Fig. 3 gezeigten Kennkurve 7 zeigen, als außen liegende SPADs 3.

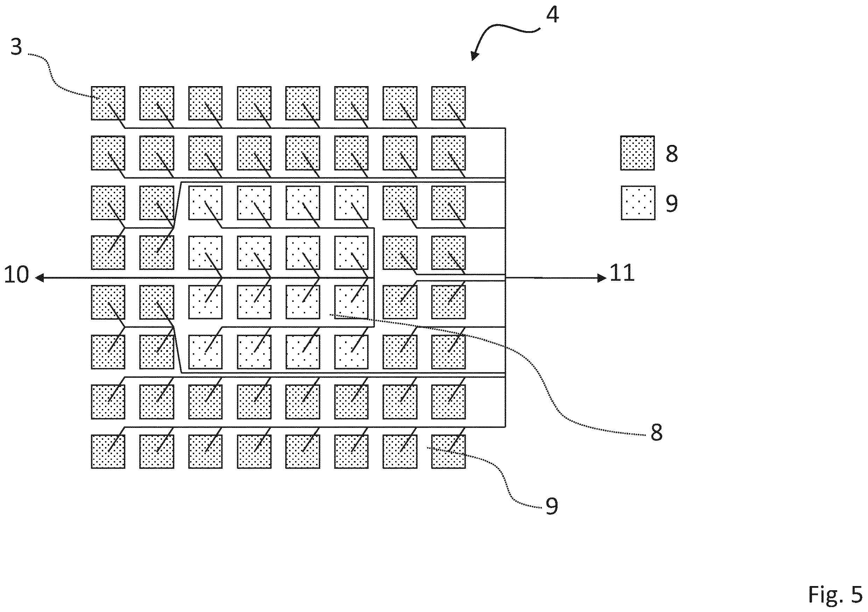

Fig. 5 zeigt in schematischer Ansicht ein erstes Ausführungsbeispiel eines Arrays 4 einer erfindungsgemäßen Vorrichtung. Das gesamte Array 4 ist dabei derart ausgebildet, dass ein erster, innen liegender Detektionsbereich 8 und ein zweiter, außen liegender Detektionsbereich 9 angeordnet ist. Der erste Detektionsbereich 8 und der zweite Detektionsbereich 9 sind jeweils als Teil-Array des gesamten Arrays 4 realisiert. Der erste Detektionsbereich 8 weist einen ersten Signalausgang 10, der zweite Detektionsbereich 9 weist einen zweiten Signal-Ausgang 11 auf. Somit sind die einzelnen Detektorbereiche 8, 9 unabhängig voneinander auslesbar. Würde man die Ausgangssignale des ersten Signal-Ausgangs 10 und des zweiten Signal-Ausgangs 11 vor jeglicher Weiterverarbeitung elektronisch zusammenführen, würde sich die Vorrichtung wie eine Vorrichtung nach dem Stand der Technik gemäß Fig. 2 verhalten.

Wird eine Vorrichtung gemäß Fig. 5 im klassischen Strahlengang eines Laser-Raster-Mikroskops eingesetzt, so wird der zweite, äußere Detektionsbereich 9 mit geringerer Lichtintensität beaufschlagt als der erste, innere Detektionsbereich 8, wenn von einem Strahlprofil gemäß Fig. 4 ausgegangen wird.

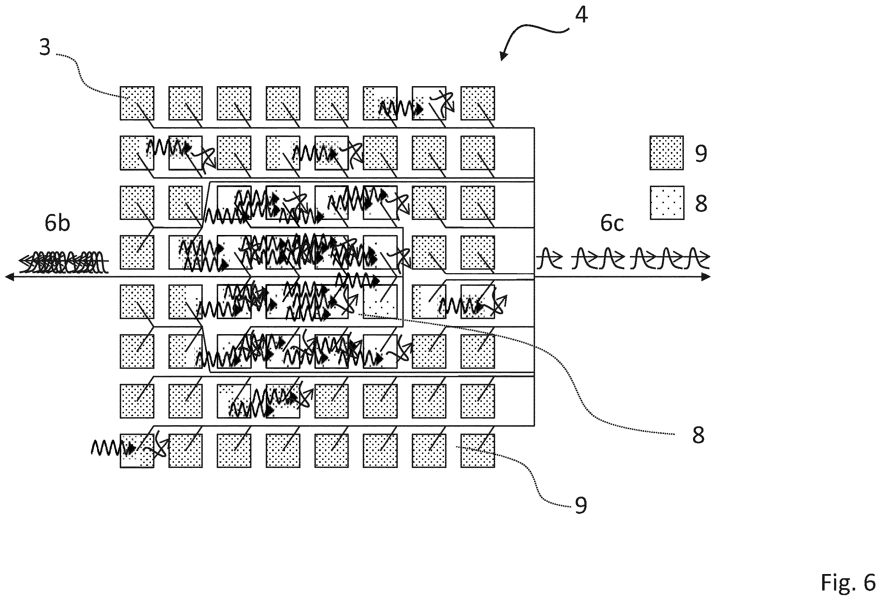

Fig. 6 zeigt in einer schematischen Ansicht die von der erfindungsgemäßen Vorrichtung nach Fig. 5 erzeugten Pulsfolgen 6b, 6c. Im inneren, ersten Detektionsbereich 8 ist die auftreffende Dichte an Photonen höher und die Wahrscheinlichkeit von gleichzeitig, d.h. innerhalb der Totzeit, auf eine SPAD 3 auftreffenden Photonen größer. Diese Vielzahl von Photonen erzeugt nur eine einzige elektrische Lawinenentladung in der SPAD 3. Der erste Detektionsbereich 8 ist daher zumindest schon teilweise gesättigt. Im äußeren, zweiten Detektionsbereich 9, ist die Photonendichte geringer, es werden alle oder nahezu alle Photonen noch einzeln erfasst. Der zweite Detektionsbereich 9 befindet sich daher noch im linearen oder nahezu linearen Bereich der Kennkurve 7. Beide Detektionsbereiche 8, 9 erzeugen Signalfolgen 6b, 6c, wobei die Signalfolge 6b des ersten Detektionsbereichs 8 mit ihren stark überlappenden Pulsen nur zur Erläuterung derart überlappend dargestellt ist. Die überlappenden Pulse werden in Realität nicht erzeugt, da in diesem Fall gleichzeitig auf eine einzelne SPAD 3 auftreffende Photonen zugrundegelegt werden müssten. Bei zwei auf unterschiedliche SPADs 3 auftreffenden Photonen sind Pulsüberschneidungen möglich.

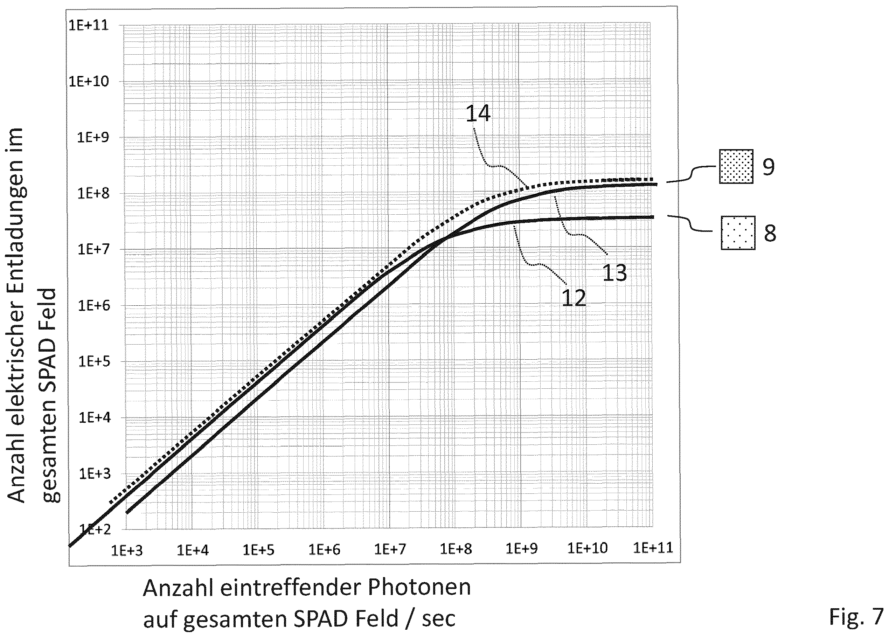

Für den ersten Detektionsbereich 8 und den zweiten Detektionsbereich 9 gelten nun Kennkurven nach Fig. 3. Eine erste Kennkurve 12 des ersten Detektionsbereichs 8 und eine zweite Kennkurve 13 des zweiten Detektionsbereichs 9 sind gegen die auf die Vorrichtung insgesamt auftreffende Gesamtlichtmenge in Fig. 7 dargestellt. Die Kennkurven 12, 13 sind aufgrund der unterschiedlichen Lichtmengen-Aufteilung und Feldgrößen gegeneinander verschoben. Des Weiteren ist in Fig. 7 die Gesamtkennkurve 14 als Summe der Kennkurven 12, 13 dargestellt.

Es ist ein zentraler Teil der Erfindung, die Ausgangssignale des ersten Detektionsbereichs 8 und des zweiten Detektionsbereichs 9 geeignet auszuwerten und vergleichend in Bezug zueinander zu setzen, um daraus die nicht-lineare Form der Gesamtkennkurve 14 zu korrigieren. Eine genauere Betrachtung von Fig. 7 zeigt, dass für Zählraten kleiner als 7×10⁷ Photonen pro Sekunde die zweite Kennkurve 13 des zweiten Detektionsbereichs 9 unter der ersten Kennkurve 12 des ersten Detektionsbereichs 8 liegt, da der zweite Detektionsbereich 9 trotz größerer Feldfläche mit insgesamt weniger Licht beaufschlagt wird. Für Zählraten größer als 7×10⁷ liegt die zweite Kennkurve 13 des zweiten Detektionsbereichs 9 über der ersten Kennkurve 12 des ersten Detektionsbereichs 8, da die relativ höheren Lichtmengen den ersten Detektionsbereich 8 bereits in die Sättigung bringen, was an der horizontal abflachenden ersten Kennkurve 12 ersichtlich ist. Der zweite Detektionsbereich 9 ist jedoch noch nicht oder weniger stark gesättigt. Die zweite Kennkurve 13 des zweiten Detektionsbereichs 9 ist noch nicht vollständig abgeflacht und das Ausgangssignal im zweiten Detektionsbereich 9 steigt mit zunehmender Lichtmenge noch weiter an.

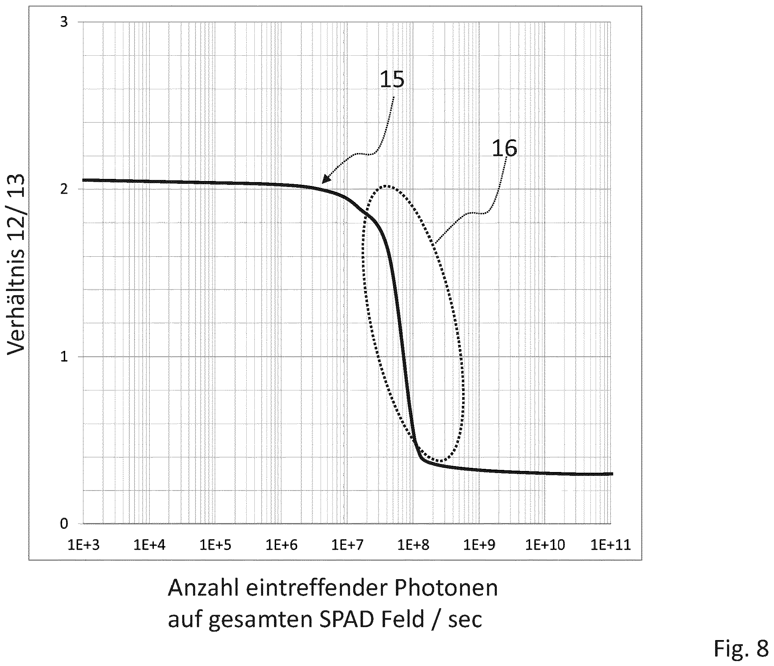

Fig. 8 zeigt ein Beispiel einer durch ein erfindungsgemäßes Verfahren erzeugten Korrekturkurve 15 für eine erfindungsgemäße Vorrichtung nach Fig. 5. Dabei ist das Verhältnis der ersten Kennkurve 12 und der zweiten Kennkurve 13 gegen die Gesamt-Lichtmenge, die auf sämtliche Detektionsbereiche 8, 9 auftrifft, aufgetragen. Anhand der sich daraus ergebenden Korrekturkurve 15 kann auf den Grad der Sättigung der Vorrichtung geschlossen werden. Für kleine Zählraten ist das Verhältnis größer 1. Für große Zählraten sinkt das Verhältnis auf unter 1. Im vollständig gesättigten Bereich des ersten Detektionsbereichs 8 und des zweiten Detektionsbereichs 9, also der Grenzwert für unendlich hohe Lichtmengen, ist das Verhältnis der Zählraten durch die Anzahl der SPADs 3 in beiden Detektionsbereichen 8, 9 gegeben. Im relevanten Bereich 16, in dem die Sättigung der Vorrichtung deutlich merkbar ist, sinkt die Korrekturkurve 15 mit großer Steigung vom Grenzwert für kleine Lichtmengen (>1) hin zum Grenzwert für große Lichtmengen (<1). Die Korrekturkurve 15 stellt also gerade im relevanten Bereich 16 der eintretenden Sättigung eine besonders empfindliche Messgröße dar, um auf die tatsächliche auf den gesamten Detektionsbereich auftreffende Gesamt-Lichtmenge zurückzuschließen. Es lässt sich nämlich aus dem Wert dieser Messgröße unmittelbar die auftreffende Gesamtlichtmenge ablesen. In dem Bereich kleiner Zählraten ist diese Messgröße nicht besonders empfindlich, da sie sich kaum ändert. Dies ist jedoch unbedeutend, da dies der ungesättigte Bereich ist, in dem die direkten Signale sämtlicher Detektionsbereiche 8, 9 unkorrigiert genutzt werden können.

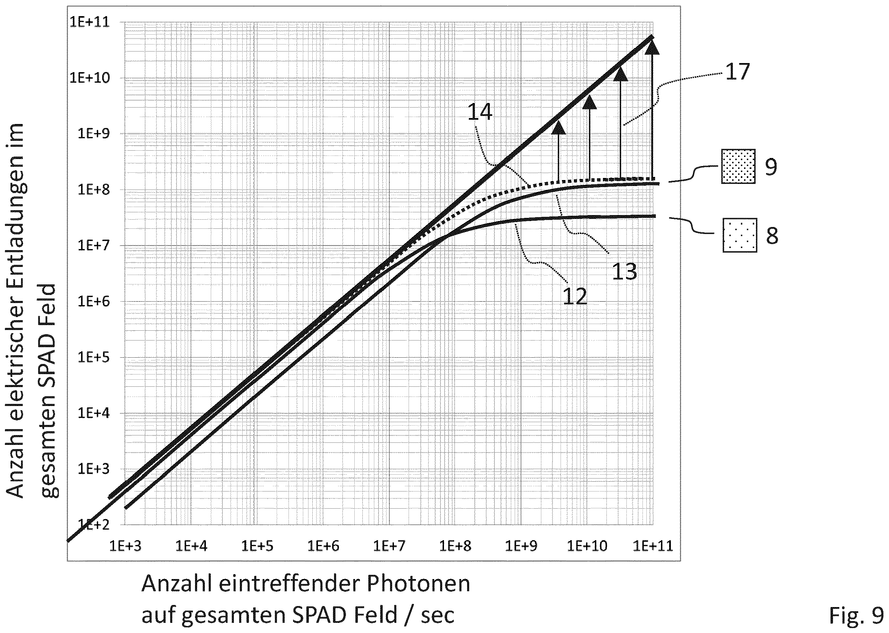

Mit Hilfe des relevanten Bereichs der Korrekturkurve 16 kann das Ausgangssignal im beginnenden Sättigungsbereich des ersten Detektionsbereichs 8 linearisiert werden, in dem ein Korrekturfaktor 17 ermittelt wird, wie dies in Fig. 9 dargestellt ist. Anhand des Korrekturfaktors 17 kann die Nichtlinearität der Gesamtkennkurve 14 korrigiert werden, um ein lineares Verhalten der Vorrichtung zu erreichen.

Diese Korrektur erfolgt bevorzugt mittels digitaler Signalverarbeitung der eigentlichen Vorrichtung nachgelagert. Das Verarbeitungsmodul kann dabei in der Vorrichtung integriert sein und beispielsweise durch einen digitalen Signalprozessor oder einen Field Programmable Gate Array realisiert werden. Die Kennkurven 8, 9 und die daraus resultierte Korrekturkurve 15 können durch eine Kalibriermessung bestimmt werden. Da für ein gegebenes Design der Vorrichtung und ein gegebenes Optik-Design eines Mikroskops die Kennkurven 8, 9 festgelegt sind, können diese für einen gegebenen Gerätetyp einmalig bestimmt werden. Die Korrektur kann dann beispielsweise auch nachgelagert in einem Rechner stattfinden und sogar wahlweise an- oder abgeschaltet werden.

Eine Konsequenz der Korrektur ist eine Änderung des SNR. Das Signal wird mit einem Korrekturfaktor 17 korrigiert und das Rauschen dieses Signals damit verstärkt. Dies ändert das SNR des Ausgangssignals der Vorrichtung. Für die Bildgebung im Lichtmikroskop ist dies aber unkritisch, da die Manipulation erst bei vergleichsweise großen Ausgangssignalen erfolgt, bei denen das SNR bereits groß ist und der Rauscheinfluss auf die Bildqualität äußerst gering ist.

Hinsichtlich weiterer vorteilhafter Ausgestaltungen der erfindungsgemäßen Vorrichtung wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele des erfindungsgemäßen Verfahrens und der erfindungsgemäßen Vorrichtung lediglich zur Erörterung der beanspruchten Lehre dienen, diese jedoch nicht auf die Ausführungsbeispiele einschränken.

## Patentansprüche

1. Verfahren zur Verbesserung des Dynamikbereichs einer Vorrichtung zum Detektieren von Licht, vorzugsweise zur Anwendung in einem Mikroskop, mit gaußartiger Verteilung des Detektionslichts auf der Detektoroberfläche, mindestens zwei Detektionsbereichen (8, 9), die jeweils aus einer Anordnung (Array) (4) aus mehreren Single-Photon-Avalanche-Dioden (SPAD) (3) gebildet sind und jeweils zumindest einen Signal-Ausgang (10, 11) aufweisen, und von denen ein erster Detektionsbereich (8) von SPADs innen in der Detektionsoberfläche und ein zweiter Detektionsbereich von SPADs außen in der Detektionsoberfläche zu liegen kommt, **dadurch gekennzeichnet, dass** für jeden der Detektionsbereiche (8, 9) eine Kennkurve (12, 13) ermittelt wird und dass die Kennkurven (12, 13) zum Erhalt einer Korrekturkurve (15) und/oder eines Korrekturfaktors (17) miteinander kombiniert und/oder verrechnet werden, wobei die Korrekturkurve (15) und/oder der Korrekturfaktor (17) durch Division der Kennkurven (12, 13) ermittelt wird.

2. Verfahren nach Anspruch 1, **dadurch gekennzeichnet, dass** eine aus den Ausgangssignalen der Signal-Ausgänge (10, 11) gebildete Gesamtkennkurve (14) anhand der Korrekturkurve (15) und/oder des Korrekturfaktors (17) korrigiert, insbesondere linearisiert, wird.

3. Verfahren nach einem der Ansprüche 1 bis 2, **dadurch gekennzeichnet, dass** die Korrektur der Ausgangssignale nach der eigentlichen Detektion des Lichts durch digitale Signalverarbeitung, beispielsweise durch einen DSP, einen FPGA oder einen Rechner, erfolgt und/oder dass die Kennkurven (12, 13) der Detektionsbereiche (8, 9) durch eine Kalibriermessung einmalig bestimmt werden.

4. Verfahren nach einem der Ansprüche 1 bis 3, **dadurch gekennzeichnet, dass** die Detektionsbereiche (8, 9) mit unterschiedlichen Intensitäten und/oder unterschiedlichen spektralen Bereichen des zu detektierenden Lichts beaufschlagt werden.

5. Verfahren nach einem der Ansprüche 1 bis 4, **dadurch gekennzeichnet, dass** die Korrektur der Ausgangssignale im Bedarfsfall zugeschaltet wird.

6. Vorrichtung zum Detektieren von Licht, insbesondere zur Anwendung in einem Mikroskop, vorzugsweise zur Durchführung des Verfahrens nach einem der Ansprüche 1 bis 5, mit mindestens zwei Detektionsbereichen (8, 9), die jeweils aus einer Anordnung (Array) (4) aus mehreren Single-Photon-Avalanche-Dioden (SPAD) (3) gebildet sind, wobei die Detektionsbereiche (8, 9) jeweils zumindest einen Signal-Ausgang (10, 11) aufweisen, und von denen ein erster Detektionsbereich (8) von SPADs innen in der Detektionsoberfläche und ein zweiter Detektionsbereich von SPADs außen in der Detektionsoberfläche zu liegen kommt, um für jeden der Detektionsbereiche (8, 9) eine Kennkurve (12, 13) ermitteln und die Kennkurven (12, 13) zum Erhalt einer Korrekturkurve (15) und/oder eines Korrekturfaktors (17) miteinander kombinieren und/oder verrechnen zu können, **dadurch gekennzeichnet, dass** die Vorrichtung ein Verarbeitungsmodul umfasst, mit dem die Korrekturkurve (15) und/oder der Korrekturfaktor (17) durch Division der Kennkurven (12, 13) ermittelt wird.

7. Vorrichtung nach Anspruch 6, **dadurch gekennzeichnet, dass** der zweite Detektionsbereich (9) den ersten Detektionsbereich (8) umschließt.

8. Vorrichtung nach Anspruch 6 oder 7, **dadurch gekennzeichnet, dass** die mindestens zwei Detektionsbereiche (8, 9) als Array (8, 9) jeweils eines Silicium-Photomultiplier (SiPM) oder jeweils als Teil-Array eines Silicium-Photomultiplier (SiPM) ausgebildet sind.

9. Vorrichtung nach Anspruch 8, **dadurch gekennzeichnet, dass** ein Strahlteiler angeordnet ist, so dass das zu detektierende Licht auf die mindestens zwei SiPM aufteilbar ist.

10. Vorrichtung nach einem der Ansprüche 6 bis 9, **dadurch gekennzeichnet, dass** ein dispersives Element, insbesondere ein Prisma oder ein Gitter, derart angeordnet ist, dass die Detektionsbereiche (8, 9) mit unterschiedlichen Spektralanteilen des zu detektierenden Lichts beaufschlagbar sind.

11. Vorrichtung einem der Ansprüche 6 bis 10, **dadurch gekennzeichnet, dass** die beiden Detektionsbereiche (8, 9) symmetrisch oder asymmetrisch zueinander angeordnet sind und/oder dass die Detektionsbereiche (8, 9) eine runde oder nahezu runde Detektionsfläche bilden.

12. Vorrichtung nach einem der Ansprüche 6 bis 11, **dadurch gekennzeichnet, dass** das Verarbeitungsmodul ein Verarbeitungsmodul zur digitalen Signalverarbeitung von Ausgangssignalen der Signal-Ausgänge (10, 11) ist, und dass das Verarbeitungsmodul als digitaler Signalprozessor (DSP) oder als Field Programmable Gate Array (FPGA) ausgebildet ist.

13. Vorrichtung nach einem der Ansprüche 6 bis 12, **dadurch gekennzeichnet, dass** die Ausgangssignale der Signal-Ausgänge (10, 11) der beiden Detektionsbereiche (8, 9), elektronisch in einem nachgelagerten Rechner zu einem einzigen Gesamtsignal zusammengeschaltet bzw. zusammengefügt werden.

14. Mikroskop, insbesondere Rastermikroskop, vorzugsweise Laser-Raster-Mikroskop, **gekennzeichnet durch** eine Vorrichtung zum Detektieren von Licht nach einem der Ansprüche 6 bis 13, wobei es sich bei dem Mikroskop um ein Mikroskop zur Fluoreszenz-Mikroskopie und/oder zur SHG-Mikroskopie und/oder zur Raman-Mikroskopie handeln könnte.

## Claims

1. Method for improving the dynamic range of a device for detecting light, preferably for application in a microscope, comprising a gaussian distribution of the detection light on the detector surface, at least two detection regions (8, 9), which are each formed from an arrangement (array) (4) of a plurality of single-photon avalanche diodes (SPADs) (3) and each have at least one signal output (10, 11), and of which a first detection region (8) of SPADs is located at an inner position in the detection surface and a second detection region of SPADs is located at an outer position in the detection surface, **characterized in that** a characteristic curve (12, 13) is determined for each of the detection regions (8, 9), and **in that** the characteristic curves (12, 13) are combined and/or computed with one another in order to obtain a correction curve (15) and/or a correction factor (17), the correction curve (15) and/or the correction factor (17) being determined by division of the characteristic curves (12, 13).

2. Method according to Claim 1, **characterized in that** an overall characteristic curve (14) formed from the output signals of the signal outputs (10, 11) is corrected, in particular linearized, on the basis of the correction curve (15) and/or the correction factor (17).

3. Method according to either of Claims 1 and 2, **characterized in that** the output signals are corrected, after the light has actually been detected, by digital signal processing, for example by a DSP, an FPGA or a computer, and/or **in that** the characteristic curves (12, 13) of the detection regions (8, 9) are ascertained once by a calibration measurement.

4. Method according to any of Claims 1 to 3, **characterized in that** the detection regions (8, 9) are impinged on by different intensities and/or different spectral ranges of the light to be detected.

5. Method according to any of Claims 1 to 4, **characterized in that** the correction of the output signals is activated as necessary.

6. Device for detecting light, in particular for application in a microscope, preferably for carrying out the method according to any of Claims 1 to 5, comprising at least two detection regions (8, 9), which are each formed from an arrangement (array) (4) of a plurality of single-photon avalanche diodes (SPADs) (3), the detection regions (8, 9) each having at least one signal output (10, 11), and of which a first detection region (8) of SPADs is located at an inner position in the detection surface and a second detection region of SPADs is located at an outer position in the detection surface, in order to be able to determine a characteristic curve (12, 13) for each of the detection regions (8, 9) and to combine and/or compute the characteristic curves (12, 13) with one another in order to obtain a correction curve (15) and/or a correction factor (17), **characterized in that** the device comprises a processing module used to determine the correction curve (15) and/or the correction factor (17) by division of the characteristic curves (12, 13) .

7. Device according to Claim 6, **characterized in that** the second detection region (9) encloses the first detection region (8).

8. Device according to Claim 6 or 7, **characterized in that** the at least two detection regions (8, 9) are embodied as an array (8, 9) in each case of a silicon photomultiplier (SiPM) or are embodied in each case as a sub-array of a silicon photomultiplier (SiPM).

9. Device according to Claim 8, **characterized in that** a beam splitter is arranged such that the light to be detected is able to be split between the at least two SiPMs.

10. Device according to any of Claims 6 to 9, **characterized in that** a dispersive element, in particular a prism or a grating, is arranged in such a way that the detection regions (8, 9) are able to be impinged on by different spectral components of the light to be detected.

11. Device according to any of Claims 6 to 10, **characterized in that** the two detection regions (8, 9) are arranged symmetrically or asymmetrically with respect to one another and/or **in that** the detection regions (8, 9) form a round or almost round detection area.

12. Device according to any of Claims 6 to 11, **characterized in that** the processing module is a processing module for the digital signal processing of output signals of the signal outputs (10, 11) and **in that** the processing module is embodied as a digital signal processing (DSP) or as a field programmable gate array (FPGA).

13. Device according to any of Claims 6 to 12, **characterized in that** the output signals of the signal outputs (10, 11) of the two detection regions (8, 9) are coupled together or merged electronically in a downstream computer to form a single overall signal.

14. Microscope, in particular scanning microscope, preferably laser scanning microscope, **characterized by** a device for detecting light according to any of Claims 6 to 13, wherein the microscope could be a microscope for fluorescence microscopy and/or for SHG microscopy and/or for Raman microscopy.

## Revendications

1. Procédé d'amélioration de la plage dynamique d'un dispositif destiné à détecter de la lumière, de préférence pour une application dans un microscope, comprenant une distribution de type gaussienne de la lumière de détection sur la surface du détecteur, au moins deux zones de détection (8, 9) qui sont respectivement formées d'un arrangement (réseau) (4) de plusieurs diodes à avalanche à photon unique (SPAD) (3) et possèdent respectivement au moins une sortie de signal (10, 11), et parmi lesquelles une première zone de détection (8) de SPAD se retrouve à l'intérieur dans la surface de détection et une deuxième zone de détection de SPAD se retrouve à l'extérieur dans la surface de détection, **caractérisé en ce qu'**une courbe caractéristique (12, 13) est identifiée pour chacune des zones de détection (8, 9) et **en ce que** les courbes caractéristiques (12, 13) sont combinées et/ou compensées entre elles en vue d'obtenir une courbe de correction (15) et/ou un facteur de correction (17), la courbe de correction (15) et/ou le facteur de correction (17) étant identifié par division des courbes caractéristiques (12, 13) .

2. Procédé selon la revendication 1, **caractérisé en ce qu'**une courbe caractéristique globale (14), formée à partir des signaux de sortie des sorties de signal (10, 11), est corrigée, notamment linéarisée, à l'aide de la courbe de correction (15) et/ou du facteur de correction (17) .

3. Procédé selon l'une des revendications 1 à 2, **caractérisé en ce que** la correction des signaux de sortie s'effectue après la détection proprement dite de la lumière par traitement numérique du signal, par exemple par un DSP, un FPGA ou un ordinateur, et/ou **en ce que** les courbes caractéristiques (12, 13) des zones de détection (8, 9) sont déterminées une fois par une mesure d'étalonnage.

4. Procédé selon l'une des revendications 1 à 3, **caractérisé en ce que** les zones de détection (8, 9) sont soumises à des intensités différentes et/ou des plages spectrales différentes de la lumière à détecter.

5. Procédé selon l'une des revendications 1 à 4, **caractérisé en ce que** la correction des signaux de sortie est mise en circuit en cas de besoin.

6. Dispositif de détection de lumière, notamment destiné à une application dans un microscope, de préférence destiné à mettre en œuvre le procédé selon l'une des revendications 1 à 5, comprenant au moins deux zones de détection (8, 9) qui sont respectivement formées d'un arrangement (réseau) (4) de plusieurs diodes à avalanche à photon unique (SPAD) (3), les zones de détection (8, 9) possédant respectivement au moins une sortie de signal (10, 11), et parmi lesquelles une première zone de détection (8) de SPAD se retrouve à l'intérieur dans la surface de détection et une deuxième zone de détection de SPAD se retrouve à l'extérieur dans la surface de détection, afin d'identifier une courbe caractéristique (12, 13) pour chacune des zones de détection (8, 9) et pour pouvoir combiner et/ou compenser les courbes caractéristiques (12, 13) entre elles en vue d'obtenir une courbe de correction (15) et/ou un facteur de correction (17), **caractérisé en ce que** le dispositif comporte un module de traitement avec lequel est identifiée la courbe de correction (15) et/ou le facteur de correction (17) par division des courbes caractéristiques (12, 13).

7. Dispositif selon la revendication 6, **caractérisé en ce que** la deuxième zone de détection (9) entoure la première zone de détection (8).

8. Dispositif selon la revendication 6 ou 7, **caractérisé en ce que** les au moins deux zones de détection (8, 9) sont réalisées sous la forme d'un réseau (8, 9) respectivement d'un photomultiplicateur en silicium (SiPM) ou respectivement sous la forme d'un réseau partiel d'un photomultiplicateur en silicium (SiPM).

9. Dispositif selon la revendication 8, **caractérisé en ce qu'**un séparateur de faisceau est disposé, de sorte que la lumière à détecter peut-être répartie sur au moins deux SiPM.

10. Dispositif selon l'une des revendications 6 à 9, **caractérisé en ce qu'**un élément dispersif, notamment un prisme ou une grille, est disposé de telle sorte que les zones de détection (8, 9) peuvent être soumises à des parts spectrales différentes de la lumière à détecter.

11. Dispositif selon l'une des revendications 6 à 10, **caractérisé en ce que** les deux zones de détection (8, 9) sont disposées de manière symétrique ou asymétrique l'une par rapport à l'autre et/ou **en ce que** les zones de détection (8, 9) forment une surface de détection ronde ou presque ronde.

12. Dispositif selon l'une des revendications 6 à 11, **caractérisé en ce que** le module de traitement est un module de traitement destiné au traitement de signal de signaux de sortie des sorties de signal (10, 11), et **en ce que** le module de traitement est réalisé sous la forme d'un processeur de signal numérique (DSP) ou d'un réseau logique programmable sur site (FPGA).

13. Dispositif selon l'une des revendications 6 à 12, **caractérisé en ce que** les signaux de sortie des sorties de signal (10, 11) des deux zones de détection (8, 9) sont interconnectés ou rassemblés électroniquement en un signal total unique dans un ordinateur situé en aval.

14. Microscope, notamment microscope à balayage, de préférence microscope à balayage laser, **caractérisé par** un dispositif de détection de lumière selon l'une des revendications 6 à 13, le microscope pouvant être un microscope destiné à la microscopie par fluorescence et/ou à la microscopie SHG et/ou à la microscopie Raman.
